(19) Europäisches Patentamt
European Patent Office
Office européen des brevets

(11) Veröffentlichungsnummer: **0 022 571**
**B1**

(12) **EUROPÄISCHE PATENTSCHRIFT**

(45) Veröffentlichungstag der Patentschrift: **22.12.82**

(51) Int. Cl.³: **G 03 C 1/72**

(21) Anmeldenummer: **80104006.4**

(22) Anmeldetag: **11.07.80**

(54) **Strahlungsempfindliches Gemisch und Verfahren zur Herstellung von Reliefbildern.**

(30) Priorität: **16.07.79 DE 2928636**

(43) Veröffentlichungstag der Anmeldung: **21.01.81 Patentblatt 81/3**

(45) Bekanntmachung des Hinweises auf die Patenterteilung: **22.12.82 Patentblatt 82/51**

(84) Benannte Vertragsstaaten: **AT BE CH DE FR GB IT LI NL SE**

(56) Entgegenhaltungen:
**DE-A-2 610 842**
**DE-A-2 718 254**

(73) Patentinhaber: **HOECHST AKTIENGESELLSCHAFT, Postfach 80 03 20, D-6230 Frankfurt/Main 80 (DE)**

(72) Erfinder: **Buhr, Gerhard, Dr., Am Erdbeerstein 28, D-6240 Königstein (DE)**
Erfinder: **Ruckert, Hans, Dr., Erbsenacker 21, D-6200 Wiesbaden-Naurod (DE)**

**EP 0 022 571 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Strahlungsempfindliches Gemisch und Verfahren zur Herstellung von Reliefbildern

Die Erfindung betrifft ein neues strahlungsempfindliches Gemisch, das als wesentliche Bestandteile a) eine Verbindung, die unter Einwirkung von aktinischer Strahlung eine Säure bildet, und b) eine polymere Verbindung mit wiederkehrenden durch Säure spaltbaren Orthocarbonsäureestergruppierungen in der Hauptkette enthält, wobei die Löslichkeit der Verbindung b) in einem flüssigen Entwickler durch Einwirkung von Säure erhöht wird.

Positiv arbeitende lichtempfindliche Kopiermaterialien, d.h. Materialien, deren Kopierschicht an den belichteten Stellen löslich wird, sind bekannt. Es haben sich vor allem die positiv arbeitenden Kopiermaterialien auf der Basis von o-Chinondiaziden in der Praxis durchgesetzt.

Die Lichtempfindlichkeit dieser Kopiermaterialien befriedigt häufig nicht. Eine Steigerung der Lichtempfindlichkeit kann man durch Verwendung katalytisch wirksamer lichtempfindlicher Systeme erreichen, da hierbei die Quantenausbeute grösser als 1 wird. So wurde das bekannte Prinzip, durch photolytisch erzeugte Säuren Folgereaktionen auszulösen und dadurch ein Löslichwerden der belichteten Stellen zu erreichen, in neuerer Zeit für positiv arbeitende Systeme genutzt. Dabei dienen photochemisch erzeugte starke Säuren zur Spaltung von speziellen nieder- und hochmolekularen Acetalen und O,N-Acetalen, die als Hydroxyl- oder Aminkomponenten aromatische Verbindungen enthalten (US-PS Nr. 3779778), und von Orthoestern und Amidacetalen (DE-AS Nr. 2610842).

Auch die Kombination von photochemischen Säurebildnern mit bestimmten Polyaldehyden und Polyketonen ist als positiv arbeitendes Kopiermaterial beschrieben worden, das bei Belichtung sichtbare Bilder liefert (US-PS Nrn. 3915704, 3915706, 3917483, 3932514 und 2892712).

Ferner beschreibt die DE-OS Nr. 2718254 ein strahlungsempfindliches Gemisch aus bestimmten aliphatischen Polyacetalen oder- ketalen und photolytischen Säurespendern, das ebenfalls positiv arbeitet.

Diese Stoffgemische sind jedoch nicht frei von Nachteilen. Polyaldehyde und Polyketone, welche als wesentliche Bestandteile die Qualität der entsprechenden Aufzeichnungsmaterialien bestimmen, können in ihren stofflichen Eigenschaften nur begrenzt variiert und den praktischen Erfordernissen angepasst werden.

Trotz der katalytischen Arbeitsweise besitzen die Kopiermaterialien, die die obengenannten Acetale und O,N-Acetale enthalten, keine befriedigende praktische Lichtempfindlichkeit. Ausserdem sind viele dieser Verbindungen nicht leicht zugänglich.

Die Polyacetale oder- ketale der DE-OS Nr. 2718254 lassen sich zwar leicht durch Veränderungen ihres Aufbaus auf viele technische Anwendungen abstimmen, erreichen in Kopiermaterialien im allgemeinen jedoch nicht die höchsten praktischen Lichtempfindlichkeiten, wie sie mit aliphatischen Orthoestern zu erzielen sind. In dieser Substanzklasse wiederum besteht Bedarf nach Verbindungen, die in Kopierschichten und -lösungen erhöhte Beständigkeit aufweisen.

Aufgabe der Erfindung war es, ein neues positiv arbeitendes, strahlungsempfindliches Gemisch vorzuschlagen, das sehr hohe Empfindlichkeit für aktinische Strahlung besitzt, insbesondere kurzwelliges Licht und Elektronenstrahlung, dessen Bestandteile leicht zugänglich sind und in diesem Gemisch eine höhere Lagerstabilität zeigen als vergleichbare bekannte Gemische.

Die Erfindung geht aus von einem strahlungsempfindlichen Gemisch, das als wesentliche Bestandteile a) eine durch Einwirkung von aktinischer Strahlung eine Säure bildende Verbindung und b) eine polymere Verbindung mit wiederkehrenden durch Säure spaltbaren Orthocarbonsäureestergruppierungen in der Hauptkette enthält, wobei die Löslichkeit der Verbindung b) in einem flüssigen Entwickler durch Einwirkung von Säure erhöht wird.

Das erfindungsgemässe Gemisch ist dadurch gekennzeichnet, dass die polymere Verbindung mit wiederkehrenden durch Säure spaltbaren Orthocarbonsäureestergruppierungen aus wiederkehrenden Einheiten der allgemeinen Formel I aufgebaut ist:

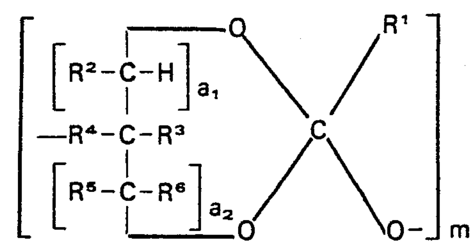

(I)

worin:

$R^1$ ein Wasserstoffatom, ein Alkyl-, Cycloalkyl- oder Arylrest ist.

$R^2$, $R^3$ und $R^5$ gleich oder verschieden sind und Wasserstoffatome, Alkyl- oder Arylreste bedeuten,

$R^4$ eine Alkylengruppe oder — wenn $a_1 = a_2 = 1$ ist — auch eine Alkylenoxygruppe, wobei die Alkylengruppen durch Heteroatome oder ungesättigte oder ringförmige Gruppen unterbrochen sein können,

$R^6$ ein Wasserstoffatom oder eine Methylgruppe,

$a_1$ und $a_2$ jeweils 0, 1 oder 2,

$a_1 + a_2$ 1 oder 2, und

m eine Zahl von 3 bis 200

bedeuten.

Als aktinische Strahlung soll im Rahmen dieser Beschreibung jede Strahlung verstanden werden, deren Energie mindestens der des kurzwelligen sichtbaren Lichts entspricht. Geeignet ist insbesondere langwellige UV-Strahlung, aber auch Elektronen-, Röntgen- und Laserstrahlung.

Als flüssige Entwickler sind insbesondere wässrige Lösungen, vorzugsweise schwach alkalische

Lösungen, aber auch organische Lösungsmittel, ggf. im Gemisch mit Wasser oder wässrigen Lösungen, zu verstehen.

In der Formel I können die Symbole im einzelnen die folgende Bedeutung haben:

$R^1$ ist z.B. Wasserstoff, eine verzweigte oder geradkettige Alkylgruppe mit 1 bis 6 C-Atomen, die durch Halogenatome, Alkoxygruppen, Acylgruppen oder Phenylgruppen substituiert sein, und olefinische Doppelbindungen enthalten kann. $R^1$ ist vorzugsweise H, Methyl, Äthyl, Cyclohexyl, Phenyl, insbesondere H.

$R^2$, $R^3$ und $R^5$ sind bevorzugt Wasserstoffatome, geradkettige oder verzweigte Alkylreste mit 1 bis 12 — insbesondere 1 bis 6 — Kohlenstoffatomen, die unsubstituiert oder z.B. durch Halogenatome, Alkoxyreste mit 1 bis 14 Kohlenstoffatomen, in denen einzelne Methylengruppen durch Sauerstoffatome ersetzt sein können, durch Alkenyloxyreste mit 3 bis 12 Kohlenstoffatomen, ggf. substituierte fünf- oder sechsgliedrige Cycloalkyloxy- oder Cycloalkenyloxyreste, ggf. substituierte Phenoxyreste, durch Benzyloxyreste, Alkylmercaptoreste mit 1 bis 12 Kohlenstoffatomen, Phenylmercaptoreste, Cycloalkyl- und Cycloalkenylreste und ggf. substituierte Phenylreste substituiert sind; ggf. substituierte Cycloalkyl- oder Cycloalkenylreste mit bevorzugt 5 oder 6 Ringkohlenstoffatomen sowie ggf. substituierte Phenylreste.

Bevorzugt sind die Verbindungen, bei denen nicht mehr als zwei, insbesondere nicht mehr als einer, der Reste $R^2$, $R^3$ und $R^5$ von Wasserstoff verschieden sind.

Wenn $R^4$ eine Alkylengruppe ist, hat diese bevorzugt bis zu 14, besonders bevorzugt 2 bis 12 Kohlenstoffatome, von denen einzelne durch Sauerstoff- oder Schwefelatome, Phenylengruppen, Cycloalkylengruppen, Carbonylgruppen, Alkenylen- oder Äthinylengruppen ersetzt sein können.

Die Alkylengruppe $R^4$ kann ferner z.B. durch Alkylgruppen mit 1 bis 8 Kohlenstoffatomen, Alkenylgruppen mit 2 bis 8 Kohlenstoffatomen, Alkoxygruppen, Halogenatome, Cycloalkyl- oder Cycloalkenylgruppen oder ggf. substituierte Phenyl- oder Phenoxygruppen substituiert sein.

Entsprechendes gilt, wenn $R^4$ eine Alkylenoxygruppe ist. $R^6$ ist bevorzugt ein Wasserstoffatom.

Verbindungen mit $a_1 + a_2 = 2$, insbesondere solche mit $a_1 = a_2 = 1$, werden bevorzugt. Die Zahl m hat bevorzugt einen Wert von 5 bis 150.

Ein Teil der polymeren Orthoester gemäss vorliegender Anmeldung ist aus der DE-OS Nr. 2715502 bekannt. Sie werden dort zur Verwendung als abbaubare Überzüge für Wirkstoffe, z.B. Arzneimittel, beschrieben.

Die erfindungsgemäss verwendeten Verbindungen mit wiederkehrenden 2-Oxy-1,3-dioxolan- oder 2-Oxy-1,3-dioxan-Einheiten können durch Kondensation von geeigneten Trihydroxyverbindungen mit niederen Orthocarbonsäureestern hergestellt werden.

Geeignete Trihydroxyverbindungen weisen zwei Hydroxygruppen in α, β- bzw. α, γ-Stellung auf, die dritte in einer Position, welche die intermolekulare Kondensationsreaktion gegenüber einer intramolekularen, zu monomeren Bicycloverbindungen führende Reaktion begünstig. So ist beispielsweise eine zweimalige 1,3-Beziehung weniger geeignet, da dann leicht Trioxabicyclooctane entstehen.

Geeignete Triole sind z.B. Glycerin, Butan-1,2,4-triol, 2-Hydroxymethylbutan-1,4-diol, Pentan-1,2,5-triol, 2-Hydroxymethylpentan-1,5-diol, Hexan-1,2,5-triol, 2-Hydroxymethylhexan-1,6-diol, Hexan-1,2,6-triol, 4-Äthylhexan-1,4,5-triol, Heptan-1,4,5-triol, 1-(1,2-Dihydroxyäthyl)-4-hydroxymethylbenzol, 2,4,6-Triäthyl-5-propylheptan-1,3,7-triol, 1-(2,3-Dihydroxypropoxy)-4-hydroxymethylbenzol, 1-(2,3-Dihydroxypropyl)-4-hydroxymethylbenzol, Oct-3-en-1,7,8-triol, Octan-1,2,8-triol, Octan-1,3,8-triol, Nonan-1,4,5-triol, 3-(1-Hydroxy-1-methyläthyl)-5-oxaoctan-2,8-diol, 2,6,8-Trimethyl-3-hydroxymethylnonan-6,7-diol, 2-Hydroxymethyl-3-oxaheptan-1,7-diol und Hexadecan-1,2,16-triol.

Beispiele für Orthoester mit einheitlichen oder gemischten niederen Esteralkylgruppen, die zur Synthese der erfindungsgemässen Polymeren eingesetzt werden können, sind Orthoameisensäuretrimethylester, -triäthylester, -tri-n-butylester, -methyldiäthylester und -äthyldiisopropylester, Orthoessigsäuretrimethylester und -triäthylester, Orthopropionsäuretrimethylester, -triäthylester und tri-n-butylester, Orthocyclohexansäuretrimethylester, Orthobenzoesäuretrimethylester, -triäthylester und -tri-n-propylester, 1,1,1-Trimethoxyprop-2-en und Orthochloressigsäuretrimethylester; vorzugsweise werden die Trimethyl- und die Triäthylester verwendet.

Die Kondensation kann ohne Lösungsmittel durch Vermischen der Komponenten im Molverhältnis 1 : 1, vorzugsweise in Gegenwart eines sauren Katalysators, wie Toluolsulfonsäure, Schwefelsäure oder eines sauren Ionenaustauschers, bei Reaktionstemperaturen von 60-170°, vorzugsweise 70-130° C, ggf. bei vermindertem Druck, vorgenommen werden. Die austretenden niederen Alkohole werden dabei kontinuierlich aus dem Reaktionsgemisch entfernt.

Vom idealen Molverhältnis 1 : 1 kann zur Regulierung des Molekulargewichtes oder zwecks Beeinflussung der Endgruppen der Polymeren ggf. abgewichen werden.

Die Polykondensationsreaktion kann vorteilhaft aber auch in Gegenwart eines unter den Reaktionsbedingungen nicht irreversibel reagierenden Lösungsmittels wie Toluol, Xylol, Dioxan oder chlorierten Kohlenwasserstoffes durchgeführt werden, wobei der austretende niedere Alkohol ggf. zusammen mit einem Teil des Lösungsmittels im Verlauf der Reaktion abdestilliert.

Verbindungen der Formel I, worin $a_1 = a_2 = 1$, $R^2 = R^5 = R^6 = H$ ist und $R^4$ eine Alkylenoxymethylgruppe $R^7-O-CH_2$ bedeutet, werden besonders bevorzugt. Es sind dies polymere Verbindungen mit wiederkehrenden Einheiten der Formel II

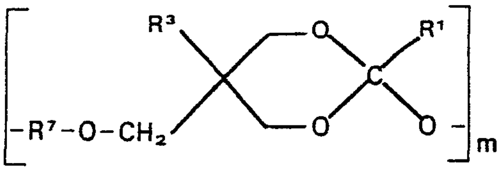

(II)

in der

$R^1$ und m die unter Formel I angegebene Bedeutung besitzen,

$R^3$ H, einen gesättigten oder ungesättigten, geradkettigen oder verzweigten aliphatischen Rest mit 1 bis 6 Kohlenstoffatomen, der z.B. durch Halogenatome, bevorzugt Chlor oder Brom, Alkoxyreste mit 1 bis 10 Kohlenstoffatomen, in denen einzelne Methylengruppen durch Sauerstoffatome ersetzt sein können, Alkenyloxyreste, ggf. substituierte Phenoxy-, Benzyloxy- oder Cycloalkoxy-, bevorzugt Cyclohexoxy- oder Alkylmercaptoreste mit 1 bis 6 Kohlenstoffatomen, ggf. substituierte Phenyl- oder Benzylmercaptoreste oder ggf. substituierte Phenylreste substituiert sein kann, einen fünf- oder sechsgliedrigen Cycloalkyl- oder Cycloalkenylreste bedeutet, und

$R^7$ einen ggf. substituierten Alkylenrest mit 2-12 Kohlenstoffatomen darstellt, in dem einzelne Methylengruppen durch Sauerstoff, Schwefel, Phenylengruppen, Alkenylen-, Alkinylen- oder Cyclohexylengruppen ersetzt sein können.

Die Substituenten des Alkylenrestes $R^7$ können z.B. sein: Alkylgruppen mit 1 bis 8 Kohlenstoffatomen, Alkenylgruppen mit 2 bis 8 Kohlenstoffatomen, Alkoxygruppen, Halogenatome, Cycloalkyl- oder Cycloalkenyl- oder ggf. substituierte Phenyl- oder Phenoxygruppen.

Die den Polymereinheiten der Formel II zugrunde liegenden Triole lassen sich einfach herstellen, indem man in bekannter Weise durch $R^3$ substituierte Trimethylolmethane in 3-Hydroxymethyloxetane überführt, die in 3-Position durch $R^3$ substituiert sind, und den Oxetanring mit einem Überschuss des Diols $HO-R^7-OH$ in Gegenwart saurer Katalysatoren spaltet. Dabei wird eine der ursprünglichen Hydroxymethylgruppen in eine verätherte Hydroxymethylgruppe übergeführt.

$R^3$ kann z.B. bedeuten Wasserstoff, Methyl, Äthyl, Propyl, Cyclohexyl, Cyclohexenyl, Phenyl, Chlormethyl, Brommethyl, Vinyl, Phenoxymethyl, Isopropyl, Phenylmercaptomethyl, Methoxymethyl, Äthoxymethyl, Allyloxymethyl und 2-Äthoxyäthoxymethyl.

Geeignete Diole $HO-R^7-OH$ sind z.B. Äthan-1,2-diol, Propan-1,2-diol, Propan-1,3-diol, Butan-1,3- und -1,4-diol, Pentan-1,5-diol, But-2-en-1,4-diol, But-2-in-1,4-diol, Neopentylglykol, 2-Methyl-2-phenylpropan-1,3-diol, Pentan-1,5-diol, 3-Methylpentan-1,5-diol, Hexan-1,5-diol, 3-Phenoxypropan-1,2-diol, 3-Äthoxypropan-1,2-diol, Diäthylenglykol, Triäthylenglykol, Thiodiglykol, Dipropylenglykol,Dibutylenglykol, Hexan-1,6-diol, Decan-1,10-diol, Dodecan-1,12-diol, 1,4-Bishydroxymethylbenzol, 1,4-Bishydroxymethylcyclohexan und 2-Phenoxypropan-1,3-diol.

Unter den strahlungsempfindlichen Gemischen sind ganz besonders diejenigen bevorzugt, die polymere Verbindungen mit Einheiten der Formel II enthalten, in der

$R^1$ Wasserstoff,

$R^3$ Methyl, Äthyl oder Chlormethyl, und

$R^7$ einen Alkylenrest mit 2 bis 12 Kohlenstoffatomen bedeutet, der durch Sauerstoffatome, Cyclohexylen- oder auch Phenylengruppen unterbrochen sein kann, und

m eine Zahl von 5 bis 150 ist.

Als den Einheiten zugrunde liegende Triole sind beispielshaft zu nennen:

2-Methyl- oder 2-Äthyl- oder 2-Chlormethyl-2-hydroxymethyl-4-oxahexan-1,6-diol,

2-Methyl- oder 2-Äthyl- oder 2-Chlormethyl-2-hydroxymethyl-4-oxaheptan-1,7-diol,

2-Methyl- oder 2-Äthyl- oder 2-Chlormethyl-2-hydroxymethyl-4-oxaoctan-1,8-diol,

2-Äthyl- oder 2-Chlormethyl-2-hydroxymethyl-5-methyl-4-oxapentan-1,7-diol,

2-Äthyl- oder 2-Chlormethyl-2-hydroxymethyl-4-oxaoctan-1,7-diol,

2-Methyl- oder 2-Äthyl-2-hydroxymethyl-4,7-dioxanonan-1,9-diol,

2-Methyl- oder 2-Äthyl-2-hydroxymethyl-4,7,10-trioxadodecan-1,12-diol,

1-Hydroxymethyl-4-(2-äthyl-3-hydroxy-2-hydroxymethyl)propoxybenzol,

2-Methyl- oder 2-Äthyl-2-hydroxymethyl-4-oxadecan-1,10-diol,

2-Methyl- oder 2-Äthyl-2-hydroxymethyl-4-oxaundecan-1,11-diol,

2-Methyl- oder 2-Äthyl-2-hydroxymethyl-4-oxadodecan-1,6-diol,

2-Äthyl-2-hydroxymethyl-7-methyl-4-oxanonan-1,9-diol,

2-Äthyl-2-hydroxymethyl-5-methyl-4,7-dioxadecan-1,9-diol,

2-Äthyl-2-hydroxymethyl-5-methyl-4-oxanonan-1,8-diol,

2-Phenyl-2-hydroxymethyl-4-oxaoctan-1,8-diol,

2,5-Dimethyl-2-hydroxymethyl-4-oxaheptan-1,7-diol,

2-Methyl-2-hydroxymethyl-4-oxaoctan-1,7-diol,

2,7-Dimethyl-2-hydroxymethyl-4-oxanonan-1,9-diol,

2,5-Dimethyl-2-hydroxymethyl-4-oxadecan-1,9-diol,

2,5-Dimethyl-2-hydroxymethyl-4-oxanonan-1,8-diol,

2-Methyl-2-hydroxymethyl-6-äthyl-6-butyl-4-oxaheptan-1,7-diol,

2,6-Diäthyl-2-hydroxymethyl-6-butyl-4-oxaheptan-1,7-diol,

2-Methyl- oder 2-Äthyl-4-oxatetradecan-1,14-diol,

2-Methyl- oder 2-Äthyl-4-oxahexadecan-1,16-diol,

1-Hydroxymethyl-4-(2,2-bishydroxymethylpropoxy)methylcyclohexan oder -benzol, und

1-Hydroxymethyl-4-(2,2-bishydroxymethylbutoxy)methylcyclohexan oder -benzol.

Durch Einsatz unterschiedlicher Triole lassen sich auch Mischpolymere herstellen. Die Umsetzung von Hydroxyendgruppen mit mehrfunktionellen Isocyanaten oder Epoxiden bietet ggf. die Möglichkeit, das Molekulargewicht zu erhöhen. Die Molekülstruktur der polymeren Orthoester lässt sich weiterhin durch Ersatz eines kleinen Anteils der verwendeten Triole durch Tetraole oder durch solche Triole modifizieren, die verglichen zur Leichtigkeit der Fünf- oder Sechsringbildung, schwieriger 1,3-Dioxacycloalkane unter Einschluss eines Orthoester-C-Atoms bilden. Wenn auf diese Weise ein gewisser Verzweigungsgrad der Polymermoleküle erzeugt wird, kann in erwünschter Weise die Löslichkeitsdifferenz zwischen belichteten und unbelichteten Anteilen erhöht werden. Voraussetzung ist, dass die Löslichkeit der verzweigten Polymeren noch ausreicht, um damit Beschichtungslösungen in geeigneten Lösungsmitteln herzustellen. Als Triole sind z.B. die Umsetzungsprodukte von Trimethylolmethan oder -äthan mit Äthylenoxid oder Heptan-1,4,7-triol geeignet.

Zur Herstellung der erfindungsgemässen positiv arbeitenden strahlungsempfindlichen Gemische werden die beschriebenen polymeren Orthoester gemischt mit Substanzen, die photochemisch oder durch Einwirkung von energiereichen Strahlen Säuren bilden bzw. abspalten. Der Mengenanteil der polymeren Orthoester an den nichtflüchtigen Bestandteilen des gesamten Gemischs kann dabei zwischen etwa 8 und 70, vorzugsweise zwischen 14 und 45 Gew.%, liegen.

Die polymeren Orthoester können ggf. auch mit anderen durch Säure spaltbaren Verbindungen, z.B. Mono- oder Bisorthoestern, wie sie in der DE-AS Nr. 2610842 beschrieben sind, oder mit Polyacetalen oder -ketalen der DE-OS Nr. 2718254 vermischt werden, wobei sich dann der angeführte Mengenanteil auf die Gesamtmenge an durch Säureeinwirkung spaltbarer Substanz bezieht.

Vorzugsweise enthalten die Gemische ferner ein polymeres, bevorzugt wasserunlösliches Bindemittel, das in organischen Lösungsmitteln löslich ist. Da sich als Entwicklerflüssigkeiten für die belichteten Kopierschichten mit Vorteil wässrigalkalische Lösungen einsetzen lassen, und diese im allgemeinen gegenüber Entwicklern auf Basis organischer Lösungsmittel vorgezogen werden, werden insbesondere solche Bindemittel bevorzugt, die in wässrigen Alkalien löslich oder mindestens quellbar sind.

Die Art und Menge der wasserunlöslichen Bindemittel kann je nach Anwendungszweck verschieden sein; bevorzugt sind Anteile am Gesamtfeststoff zwischen 30 und 90, besonders bevorzugt zwischen 55 und 85 Gew.%.

Die bei vielen Positivkopiermaterialien bewährten Phenolharze, vor allem Novolake, haben sich auch bei den erfindungsgemässen Gemischen als besonders brauchbar und vorteilhaft erwiesen. Sie fördern die starke Differenzierung zwischen den belichteten und unbelichteten Schichtpartien beim Entwickeln, besonders die höher kondensierten Harze mit substituierten Phenolen, z.B. Kresolen, als Formaldehyd-Kondensationspartner. Die Novolake können auch in bekannter Weise durch Umsetzung eines Teils ihrer Hydroxygruppen, z.B. mit Chloressigsäure, Isocyanaten, Epoxiden oder Carbonsäureanhydriden, modifiziert sein. Andere alkalilösliche Harze, wie Mischpolymerisate aus Maleinsäureanhydrid und Styrol, Vinylacetat und Crotonsäure, Methylmethacrylat und Methacrylsäure und dgl. sind ebenfalls als Bindemittel geeignet.

Zusätzlich können noch zahlreiche andere Harze mitverwendet werden, die entweder wasserlöslich oder aber alkaliunlöslich sein können, bevorzugt Vinylpolymerisate wie Polyvinylacetate; Polyacrylate, Polyvinyläther und Polyvinylpyrrolidone, die selbst durch Comonomere modifiziert sein können. Der günstigste Anteil an diesen Harzen richtet sich nach den anwendungstechnischen Erfordernissen und dem Einfluss auf die Entwicklungsbedingungen und beträgt im allgemeinen nicht mehr als 20% vom alkalilöslichen Harz. In geringen Mengen kann die lichtempfindliche Schicht für spezielle Erfordernisse wie Flexibilität, Haftung, Glanz usw. ausserdem noch Substanzen wie Polyglykole, Celluloseäther, z.B. Äthylcellulose, Netzmittel, Farbstoffe und feinteilige Pigmente enthalten.

Als strahlungsempfindliche Komponenten, die beim Bestrahlen vorzugsweise starke Säuren bilden bzw. abspalten, sind eine grosse Anzahl von bekannten Verbindungen und Mischungen, wie Diazonium-, Phosphonium-, Sulfonium- und Jodoniumsalze, Halogenverbindungen, o-Chinondiazidsulfochloride und Organometall/Organohalogen-Kombinationen geeignet.

An Diazonium-Salzen kommen die in der Diazotypie bekannten Verbindungen mit ausnutzbarer Absorption zwischen 300 und 600 nm in Frage. Einige erprobte und erfahrungsgemäss ausreichend lagerfähige Diazonium-Verbindungen sind in den Beispielen genannt; bevorzugt werden Verbindungen, die keine basischen Substituenten enthalten.

Die genannten Diazonium-, Phosphonium-, Sulfonium- und Jodoniumverbindungen werden in der Regel eingesetzt in Form ihrer in organischen Lösungsmitteln löslichen Salze, meist als Abscheidungsprodukt mit komplexen Säuren wie Borfluorwasserstoffsäure, Hexafluorphosphor-, Hexafluorantimon- und -arsensäure.

Es können aber auch Halogenide der positiv arbeitenden o-Chinondiazide verwendet werden. Die Azidität der beim Belichten von o-Naphthochinondiaziden entstehenden Indencarbonsäuren reicht meist nur knapp für eine ausreichende bildmässige Differenzierung aus. Bevorzugt wird aus dieser Gruppe das Naphthochinon-1,2-diazid-(2)-4-sulfochlorid, bei dessen Belichtung drei Säurefunktionen gebildet werden, so dass ein relativ grosser Verstärkungsfaktor bei der Spaltung der polymeren Orthoester entsteht.

Grundsätzlich sind als halogenhaltige strahlungsempfindliche und Halogenwasserstoffsäure bildende Verbindungen alle auch als photochemische Radikalstarter bekannten organischen Halogenverbindungen brauchbar, beispielsweise solche mit mehr als einem Halogenatom an einem

Kohlenstoffatom oder an einem aromatischen Ring. Beispiele sind in den US-PS Nrn. 3515552, 3536489 und 3779778, der DE-AS Nr. 2610842 und den DE-OS Nr. 2718259 und DE-OS Nr. 2243621 beschrieben. Die Wirkung dieser halogenhaltigen Verbindungen kann auch für die erfindungsgemässen Positivkopierschichten durch an sich bekannte Sensibilisatoren spektral beeinflusst und gesteigert werden.

Beispiele für geeignete Starter sind:

4-(Di-n-propylamino)benzoldiazoniumtetrafluoroborat,

4-p-Tolylmercapto-2,5-diäthoxybenzoldiazoniumhexafluorophosphat und -tetrafluoroborat, Diphenylamin-4-diazoniumsulfat, 4-Methyl-6-trichlormethyl-2-pyron,

4-(3,4,5-Trimethoxystyryl)-6-trichlormethyl-2-pyron,

4-(4-Methoxystyryl)-6-(3,3,3-trichlorpropenyl)-2-pyron,

2-Trichlormethylbenzimidazol, 2-Tribrommethylchinolon,

2,4-Dimethyl-1-tribromacetylbenzol, 3-Nitro-1-tribromacetylbenzol, 4-Dibromacetylbenzoesäure, 1,4-Bisdibrommethylbenzol, Trisdibrommethyl-s-triazin, 2-(6-Methoxynaphth-2-yl)-, 2-(Naphth-1-yl)-, 2-(Naphth-2-yl)-, 2-(4-Äthoxyäthylnaphth-1-yl)-, 2-(Benzopyran-3-yl)-, 2-(4-Methoxyanthrac-1-yl)-, 2-(Phenanthr-9-yl)-4,6-bistrichlormethyl-s-triazin und die in den Beispielen angeführten Verbindungen.

Die Menge des Starters kann je nach seiner chemischen Natur und der Zusammensetzung des Gemischs ebenfalls sehr verschieden sein. Günstige Ergebnisse werden erhalten mit etwa 0,1 bis 10 Gew.%, bezogen auf den Gesamtfeststoff, bevorzugt sind 0,2 bis 5%. Besonders für Kopierschichten von Dicken über 10 µm empfiehlt es sich, relativ wenig Säurespender zu verwenden.

Schliesslich können dem lichtempfindlichen Gemisch noch lösliche oder auch feinteilige dispergierbare Farbstoffe sowie je nach Anwendungszweck auch UV-Absorber zugesetzt werden. Als Farbstoffe haben sich die Triphenylmethanfarbstoffe, insbesondere in der Form ihrer Carbinolbasen, besonders bewährt. Die günstigsten Mengenverhältnisse der Komponenten lassen sich im Einzelfall durch Vorversuche leicht ermitteln.

Geeignete Lösungsmittel für das erfindungsgemässe Stoffgemisch sind Ketone wie Methyläthylketon; chlorierte Kohlenwasserstoffe wie Trichloräthylen und 1,1,1-Trichloräthan, Alkohole wie n-Propanol, Äther wie Tetrahydrofuran, Alkoholäther wie Äthylenglykolmonoäthyläther und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren.

Die Wahl der Lösungsmittel ist jedoch auf das vorgesehene Beschichtungsverfahren, die Schichtdicke und die Trocknungsvorrichtung abzustimmen. Dünne Schichten bis ca. 5 µm werden für Versuchsmengen vorzugsweise auf der Schleuder durch Aufgiessen aufgetragen. Mit Lösungen bis zu ca. 40% Feststoffgehalt sind so mit einmaligem Auftrag oder mit einer Streichrakel Schichtdicken von mehr als 60 µm erreichbar. Für beidseitige Beschichtung wird Tauchbeschichtung vorgezogen, wobei durch Verwendung von niedrig siedenden Lösungsmitteln schnelles Antrocknen von Vorteil ist. Bandbeschichtung erfolgt durch Antragen mittels Walzen, Breitschlitzdüsen oder Sprühen; Einzelplatten wie Zink- und Mehrmetallplatten können durch Giessantrag (curtaincoater) beschichtet werden.

Im Vergleich zu anderen Positivschichten, besonders denen auf o-Naphthochinondiazidbasis, ist die Herstellung dickerer Schichten vorteilhaft möglich, da die Lichtempfindlichkeit des erfindungsgemässen Gemischs verhältnismässig wenig dickenabhängig ist. Belichtung und Verarbeitung von Schichtdicken bis ca. 100 µm und darüber ist möglich.

Bevorzugte Träger für Schichten von mehr als 10µm Dicke sind Kunststoffolien, die dann als temporäre Träger für Transferschichten dienen. Dafür und für Farbfolien werden Polyesterfolien, z.B. aus Polyäthylenterephthalat, bevorzugt. Polyolefinfolien wie Polypropylen sind jedoch ebenfalls geeignet. Als Schichtträger für Schichtdicken unter ca. 10 µm werden meist Metalle verwendet. Für Offsetdruckplatten können eingesetzt werden: Mechanisch oder elktrochemisch aufgerauhtes und ggf. anodisiertes Aluminium, das zudem noch chemisch, z.B. mit Polyvinylphosphonsäure, Silikaten oder Phosphaten, vorbehandelt sein kann, ausserdem Mehrmetallplatten mit Cu/Cr oder Messing/Cr als oberster Schicht. Für Hochdruckplatten können die erfindungsgemässen Schichten auf Zink- oder Magnesiumplatten sowie deren handelsübliche mikrokristalline Legierungen für Einstufenätzverfahren aufgetragen werden, ausserdem auf ätzbare Kunststoffe wie Polyoxymethylen. Für Tiefdruck- oder Siebdruckformen eignen sich die erfindungsgemässen Schichten durch ihre gute Haftung und Ätzfestigkeit auf Kupfer- bzw. Nickeloberflächen. Ebenso lassen sich die erfindungsgemässen Gemische als Photoresists und beim Formteilätzen verwenden.

Schliesslich kann die Beschichtung direkt oder durch trockene Schichtübertragung vom temporären Träger erfolgen auf Leiterplattenmaterialien, die aus Isolierplatten mit ein- oder beidseitiger Kupferauflage bestehen, auf Glas oder Keramikmaterialien, die ggf. haftvermittelnd vorbehandelt sind, und u.a. auf Silizium-, Siliziumoxid- und Siliziumnitridscheiben. Ausserdem können Holz, Textilien und Oberflächen vieler Werkstoffe beschichtet werden, die vorteilhaft durch Projektion bebildet werden und resistent gegen die Einwirkung alkalischer Entwickler sind.

Für die Trocknung nach der Beschichtung können die üblichen Geräte und Bedingungen übernommen werden, Temperaturen um 100° C und kurzfristig bis 120° C werden ohne Einbusse an Strahlungsempfindlichkeit vertragen.

Zum Belichten können die üblichen Kopiergeräte wie Röhrenlampen, Xenonimpulslampen, metallhalogeniddotierte Quecksilberdampf-Hochdrucklampen und Kohlebogenlampen verwendet werden. Darüber hinaus ist bei den lichtempfindlichen polymere Orthoester enthaltenden Schichten das Belichten in üblichen Projektions- und Vergrösserungsgeräten unter dem Licht der Metallfadenlampen und Kontaktbelichtung mit gewöhnlichen Glühbirnen möglich. Die Belichtung kann auch mit kohärentem Licht eines Lasers erfolgen. Geeignet für die Zwecke vorliegender Erfindung sind leistungsgerechte kurzwellige Laser, beispielsweise Argon-Laser, Krypton-Ionen-Laser, Farbstoff-Laser und Helium-Cadmium-Laser, die zwischen 300 und 600 nm emittieren. Der Laserstrahl wird mittels einer vorgegebenen programmierten Strich- und/oder Rasterbewegung gesteuert.

Das Bestrahlen mit Elektronenstrahlen ist eine weitere Bebilderungsmöglichkeit. Elektronenstrahlen können das erfindungsgemässe Gemisch wie auch viele andere organische Materialien durchgreifend zersetzen und vernetzen, so dass ein negatives Bild entsteht, wenn die unbestrahlten Teile durch Lösungsmittel oder Belichten ohne Vorlage und Entwickeln entfernt werden. Bei geringerer Intensität und/oder höherer Schreibgeschwindigkeit des Elektronenstrahls bewirkt dagegen der Elektronenstrahl eine Differenzierung in Richtung höherer Löslichkeit, d.h. die bestrahlten Schichtpartien können vom Entwickler entfernt werden. Es wurde gefunden, dass die erfindungsgemässen Schichten erheblich elektronenstrahlempfindlicher als übliche Naphthochinondiazidschichten sind und — wie in den Beispielen erläutert — ein breiter Bandbereich vergleichsweise geringer Energieeinwirkung von Elektronenstrahlen ausgenutzt werden kann. Die Wahl der günstigsten Bedingungen kann durch Vorversuche leicht ermittelt werden.

Die bildmässig belichtete oder bestrahlte Schicht kann mit praktisch den gleichen Entwicklern wie für handelsübliche Naphthochinondiazidschichten und Kopierlacke entfernt werden, bzw. die neuen Schichten können in ihren Kopierbedingungen vorteilhaft auf die bekannten Hilfsmittel wie Entwickler und programmierte Sprühentwicklungsgeräte abgestimmt werden. Die wässrigen Entwicklerlösungen können z.B. Alkaliphosphate, -silikate oder -hydroxide und ferner Netzmittel sowie kleinere Anteile organischer Lösungsmittel enthalten. In bestimmten Fällen sind auch Lösungsmittel/Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden. Zur Erhöhung der Widerstandsfähigkeit beim Druck sowie der Resistenz gegen Auswaschmittel, Korrekturmittel und durch UV-Licht härtbare Druckfarben können die entwickelten Platten kurze Zeit auf erhöhte Temperaturen erwärmt werden, wie es für Diazoschichten aus der britischen Patentschrift Nr. 1154749 bekannt ist.

Erfindungsgemäss wird auch ein Verfahren zur Herstellung von Reliefbildern vorgeschlagen, bei dem man ein strahlungsempfindliches Aufzeichnungsmaterial aus einem Träger und einer Aufzeichnungsschicht, die als wesentliche Bestandteile a) eine Verbindung, die unter Einwirkung von aktinischer Strahlung eine Säure bildet, und b) eine polymere Verbindung mit wiederkehrenden, durch Säure spaltbaren Orthocarbonsäureestergruppierungen in der Hauptkette enthält, wobei die Löslichkeit der Verbindung b in einem flüssigen Entwickler durch Einwirkung von Säure erhöht wird, bildmässig mit aktinischer Strahlung in solcher Dosis bestrahlt, dass die Löslichkeit der Schicht in einem flüssigen Entwickler zunimmt, und die bestrahlten Schichtteile mittels eines flüssigen Entwicklers auswäscht. Das Verfahren ist dadurch gekennzeichnet, dass man eine polymere Verbindung b der allgemeinen Formel I verwendet

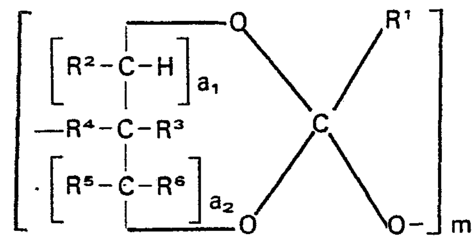

(I)

worin

$R^1$ ein Wasserstoffatom, ein Alkyl-, Cycloalkyl- oder Arylrest ist,

$R^2$, $R^3$ und $R^5$ gleich oder verschieden sind und Wasserstoffatome, Alkyl- oder Arylreste bedeuten, eine Alkylengruppe oder — wenn $a_1 = a_2 = 1$ ist — auch eine Alkylenoxygruppe, wobei die Alkylengruppen durch Heteroatome oder ungesättigte oder ringförmige Gruppen unterbrochen sein können,

$R^6$ ein Wasserstoffatom oder eine Methylgruppe,

$a_1$ und $a_2$ jeweils 0, 1 und 2,

$a_1 + a_2$ 1 oder 2, und

m eine Zahl von 3 bis 200

bedeuten.

Wenn das Verfahren mit Elektronenstrahlung durchgeführt wird, sind neben den bekannten für sichtbares und nahes UV-Licht empfindlichen photolytischen Säurespendern auch solche geeignet, deren Absorptionsbereiche im kürzerwelligen Teil des elektromagnetischen Spektrums liegen und die damit gegenüber Tageslicht wenig empfindlich sind. Dies hat den Vorteil, dass man die Aufzeichnungsmaterialien ohne Lichtausschluss handhaben kann, und dass die Materialien besser lagerfähig gemacht werden können.

Beispiele für derartige Starter sind Tribrommethylphenylsulfon, 2,2',4,4',6,6'-Hexabromdiphenylamin, Pentabromäthan, 2,3,4,5-Tetrachloranilin, Pentaerythrittetrabromid, Chlorterphenylharze oder chlorierte Paraffine.

Die unter Einwirkung von Elektronenstrahlung säurebildende Verbindung kann aber auch der polymere Orthocarbonsäureester selbst sein, wenn er an geeigneter Stelle durch Halogenatome, insbesondere Chlor, Brom oder Jod substituiert ist.

Die erfindungsgemässen Gemische können

auch durch Röntgenstrahlung solubilisiert werden.

Im folgenden werden Beispiele für die erfindungsgemässen lichtempfindlichen Gemische angegeben. Dabei wird zunächst die Herstellung einer Anzahl neuer polymerer Orthoester beschrieben, die in erfindungsgemässen Gemischen als durch Säure spaltbare Verbindungen erprobt wurden. Sie sind als Verbindungen 1 bis 16 durchnumeriert und kehren unter dieser Bezeichnung in den Anwendungsbeispielen wieder.

In den Beispielen stehen Gewichtsteile (Gt) und Volumteile (Vt) im Verhältnis von g zu ccm. Prozent- und Mengenverhältnisse sind, wenn nichts anderes angegeben ist, in Gewichtseinheiten zu verstehen.

*Allgemeine Vorschrift zur Herstellung der polymeren Orthoester, Verbindungen 1-15.*

1 mol Triol $HO-R^7-OCH_2-\overset{R^3}{\overset{|}{C}}(-CH_2OH)_2$, 1,03 mol Orthocarbonsäuretrimethyl- oder -triäthylester, 0,75 g p-Toluolsulfonsäure und 800 ml Toluol werden unter Rühren langsam auf 100° C erhitzt, wobei im Verlauf von 2,5 h über eine aufgesetzte Vigreux-Kolonne ungefähr 100 g bzw. 150 g eines Alkohol/Toluolgemisches abdestillieren. Die Temperatur wird auf 115° C gesteigert, und während der folgenden 3,5 h werden nochmals etwa 200 g Destillat aufgefangen. Der Kolbeninhalt wird mit 3 g Kaliumcarbonat verrührt und anschliessend filtriert.

Die Gehaltsbestimmung der so gewonnenen klaren Lösung des polymeren Orthoesters erfolgt durch Eindampfen eines aliquoten Teils unter vermindertem Druck und Erhitzen des Rückstandes in einer Kugelrohrapparatur bei 60° C und $10^3$ mbar während 1 h. Die Molekulargewichte wurden dampfdruckosmometrisch bestimmt. Sie stellen untere Werte des Zahlenmittels dar, da bereits geringe Mengen Restlösungsmittel den Wert von $\overline{M}_n$ zu niedrigeren Werten verfälschen. In Spalte 2 der Tabelle 1 ist angegeben, ob zur Herstellung der entsprechende Orthocarbonsäuretrimethyl- (M) oder -triäthylester (E) verwendet wurde.

Tabelle 1

| Verbindung Nr. | Verwendeter Orthoester | Verbindungen | | | |
|---|---|---|---|---|---|
| | | $R^1$ | $R^3$ | $R^7$ | $\overline{M}_n$ |
| 1 | M | H | $C_2H_5$ | $-(CH_2)_2-$ | 1290 |
| 2 | M | H | $C_2H_5$ | $-(CH_2)_3-$ | 1680 |
| 3a* | M | H | $C_2H_5$ | $-(CH_2)_4-$ | 1470 |
| 3b | E | H | $C_2H_5$ | $-(CH_2)_4-$ | 1530 |
| 4 | M | H | $C_2H_5$ | $-CH_2-CH_2-\underset{CH_3}{\underset{\vert}{C}H}-$ oder $-\underset{CH_3}{\underset{\vert}{C}H}-CH_2-CH_2-$ | 1110 |
| 5 | M | H | $C_2H_5$ | $-CH_2CH_2OCH_2CH_2-$ | 1540 |
| 6 | M | H | $C_2H_5$ | $-(CH_2CH_2O)_2CH_2CH_2-$ | 1630 |
| 7 | M | H | $CH_3$ | $-(CH_2)_4-$ | 2580 |
| 8 | M | H | $CH_3$ | $-(CH_2)_{10}-$ | 1540 |
| 9 | M | H | $C_2H_5$ | $-CH_2-$ 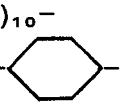 $-CH_2-$ | 2420 |
| 10 | M | H | $ClCH_2$ | $-(CH_2)_4-$ | 1410 |
| 11 | E | $CH_3$ | $CH_3$ | $-(CH_2)_4-$ | 1370 |
| 12 | E | $C_2H_5$ | $CH_3$ | $-(CH_2)_4-$ | 930 |
| 13 | E | Phenyl | $C_2H_5$ | $-(CH_2)_4-$ | 1240 |
| 14 | M | Cyclohexyl | $C_2H_5$ | $-(CH_2)_4-$ | 1280 |
| 15 | M | H | $C_2H_5$ | $-CH_2-CH=CH-CH_2-$ | 1390 |

* Deutlich höhere Molekulargewichte wurden durch Gelpermeationschromatographie ermittelt. Die Verbindung 3a zeigt hierbei neben wenig niedermolekularen Anteilen eine Verteilung zwischen 1000 und ca. 20 000 Molekulargewichtseinheiten mit Maxima bei 4200, 13 000 und 20 000 an. Zur Aufnahme des Chromatogramms wurde das Gerät Spectra Physics 8000 mit einem Differentialdiffraktometer als Detektor verwendet. Die Trennung erfolgte an vier Säulen von je 500 mm Länge und 8 mm Durchmesser (3 Säulen Varian G 2000 H, 1 Säule G 3000 H), gefüllt mit vernetztem Polystyrol. Als Eluens wurde Tetrahydrofuran verwendet. Als Vergleich dienten definierte Polyethylenglykole mit enger Molekulargewichtsverteilung.

*Herstellung des polymeren Orthoesters Verbindung 16*

23,65 g 1,2,6-Hexantriol, 22,5 g Orthoameisensäuretrimethylester und 25 mg p-Toluolsulfonsäure werden unter Rühren und Abdestillieren von Methanol in 5 h nach und nach auf eine Endtemperatur von 160°C erhitzt. Die Masse wird mit 50 ml Äther verdünnt, mit 0,7 g Kaliumcarbonat verrührt, filtriert und unter vermindertem Druck vom Lösungsmittel befreit. Man erhält 27,8 g polymeren Orthoester, dessen IR-Absorptionsspektrum keine Hydroxylgruppen und nur sehr geringen Carbonylgehalt ausweist.

*Beispiele 1-6*

Auf a mechanisch aufgerauhtes oder b elektrolytisch aufgerauhtes und anodisiertes Aluminium ca. 2 µm dick aufgetragene Schichten der Zusammensetzung

77 Gt Kresol-Formaldehyd-Novolak (Schmelzbereich 105-120°C nach DIN 53181), und
23 Gt polymerer Orthoester,

die gegebenenfalls noch

4 Gt Säurespender und/oder
0,6 Gt Kristallviolettbase enthalten,

werden mit 11 kV-Elektronen bestrahlt. Unter den in der Tabelle 2 genannten Bedingungen werden die bestrahlten Stellen in dem Entwickler der folgenden Zusammensetzung löslich:

5,5 Gt Natriummetasilikat · 9 $H_2O$,
3,4 Gt Trinatriumphosphat · 12 $H_2O$,
0,4 Gt Mononatriumphosphat, wasserfrei,
90,7 Gt vollentsalztes Wasser.

Die Entwicklungszeit beträgt in allen Fällen 1 min.

Tabelle 2

| Beispiel Nr. | Träger | Säurespender | Verbindung Nr. | Eingestrahlte Energie ($J/cm^2$) | Farbstoff |
|---|---|---|---|---|---|
| 1 | a | 2-(4-Äthoxy-naphth-1-yl)-4,6-bis-trichlormethyl-s-triazin | 2 | $3\text{-}140 \cdot 10^{-2}$ | ja |
| 2 | a | Tristrichlormethyl-s-triazin | 7 | $1\text{-}90 \cdot 10^{-2}$ | ja |
| 3 | a | Chlorparaffinharz | 8 | $0{,}8\text{-}90 \cdot 10^{-2}$ | ja |
| 4 | a | ohne | 10 | $18\text{-}120 \cdot 10^{-2}$ | nein |
| 5 | b | ohne | 10 | $36\text{-}180 \cdot 10^{-2}$ | nein |
| 6 | a | ohne | 10 | $70\text{-}180 \cdot 10^{-2}$ | ja |

*Beispiel 7*

Zur Herstellung einer Rückvergrösserungsplatte werden

4,0 Gt des in Beispiel 1 angegebenen Novolaks, und
1,2 Gt Verbindung Nr. 11, 12 oder 16,
0,2 Gt 2-Acenaphth-5-yl-4,6-bistrichlormethyl-s-triazin in
94,6 Gt Methyläthylketon

gelöst und auf eine Platte aus gebürstetem Aluminium aufgeschleudert.

Belichtet wird 1,5 min lang mit einem Projektor Leitz Prado f = 85 mm; 1:2,5 mit einer 150-W-Lampe durch ein Diapositiv im Abstand von 65 cm. Durch Tauchen in den in Beispiel 1 angegebenen Entwickler erhält man innerhalb von 30 s eine vergrösserte Positivkopie des schwarzweissen Strichbildes auf dem Diapositiv, die mit Fettfarbe eingefärbt und durch Drucken in einer Kleinoffsetmaschine vervielfältigt werden kann.

Mit ähnlichem Ergebnis können anstelle der Verbindungen Nr. 11, 12 oder 16 die Verbindungen Nr. 1, 13 oder 14 verwendet werden, wenn die Belichtungsdauer auf 2 min verlängert wird.

*Beispiele 8-12*

Die verbesserte hohe thermische Stabilität der erfindungsgemässen Kopiermassen wird in diesen Beispielen im Vergleich zu entsprechenden Kopierschichten auf der Basis von in der DE-AS Nr. 2610842 beschriebenen Orthoestern, nämlich mit einem Bisorthoester mit 1,3-Dioxanyleinheiten und einem thermisch bereits recht stabilen polymeren Orthoester aus einem Tetrol (Vergleichsbeispiele A und B) aufgezeigt. Mangelnde thermische Stabilität äussert sich gelegentlich im Rückgang der Entwicklerresistenz, d.h. in nicht ausreichender Differenzierung zwischen belichteten und unbelichteten Schichtpartien beim Entwicklungsvorgang. Häufiger zeigt sich mangelnde thermische Stabilität jedoch durch deutliche Zunahme der erforderlichen Entwicklungszeit; in extremen Fällen lösen sich auch die vom Licht getroffenen Stellen nicht mehr in dem üblicherweise verwendeten Entwickler. Die forcierte thermische Belastung wird als Schnelltest für die Lagerstabilität bei Raumtemperatur oder mässig erhöhter Temperatur angesehen. Aluminiumplatten mit elektrolytisch aufgerauhter und anodisierter Oberfläche werden mit einer ca. 2 µm dicken Schicht der folgenden Zusammensetzung versehen:

73,5% Novolak nach Beispiel 1,
22,2% Orthoester,
3,7% des Säurespenders aus Beispiel 1, und
0,6% Kristallviolettbase.

Die Beschichtung erfolgt durch Aufschleudern einer 6%igen Methyläthylketonlösung. Die Platten werden jeweils gleiche Zeit bei 100° C im Trockenschrank erhitzt, durch eine Testvorlage mit einer 5-kW-Metallhalogenlampe im Abstand von 110 cm 15 s belichtet und mit dem Entwickler aus Beispiel 1 entwickelt.

Die Veränderung der erforderlichen Entwicklungszeiten in Abhängigkeit von der Dauer der thermischen Belastung zeigt die folgende Tabelle 3.

Tabelle 3

| Beispiel | Orthoester | Entwicklungsdauer (s) nach Erhitzen von | | | | |
|---|---|---|---|---|---|---|
| | | 0 | 1 | 3 | 5 | 7 (h) |
| A | Polymerer Orthoester aus Dispiro-3,11-dimethoxy-2,4,10,12-tetraoxa-[5.1.5.2]-pentadecan-7-on und Triäthylenglykol | 30 | 40 | 45 | 60 | 120 |
| B | Bis-(5-äthyl-5-butyl-1,3-dioxan-yl)äther des 2-Äthyl-2-butyl-1,3-propan-diols | 30 | 30 | 120 | 240* | — |
| 8 | Verbindung Nr. 2 | 20 | 30 | 30 | 30 | 35 |
| 9 | Verbindung Nr. 3 | 20 | 30 | 30 | 30 | 30 |
| 10 | Verbindung Nr. 5 | 15 | 20 | 30 | 35 | 45 |
| 11 | Verbindung Nr. 7 | 15 | 15 | 15 | 15 | 15 |
| 12 | Verbindung Nr. 8 | 40 | 50 | 50 | 50 | 50 |

* Nicht mehr völlig tonfrei entwickelbar.

*Beispiel 13*

Eine Offsetdruckform wird in folgender Weise hergestellt:

Auf eine elektrolytisch aufgerauhte und anodisierte Aluminiumplatte wird eine Beschichtungslösung aus

4,0 Gt Novolak nach Beispiel 1,
1,2 Gt Verbindung Nr. 7,
0,2 Gt 2-(4-Methoxy-naphth-1-yl)-4,6-bistrichlormethyl-s-triazin,
0,04 Gt Kristallviolettbase, und
94,6 Gt Butylacetat/Äthylenglykolmonomethyläther im Volumenverhältnis 1:1

zu einem Trockengewicht von 2,0 g/m² aufgeschleudert, und 15 s unter den Bedingungen von Beispiel 8 bildmässig belichtet, wonach ein starker blauviolett-blaugrüner Bildkontrast zu sehen ist.

Die Platte wird durch Überwischen mit dem Entwickler von Beispiel 1 in 45 s zu einem positiven Abbild der Vorlage entwickelt.

Ein Druckversuch mit dieser Druckplatte wird nach 100 000 Drucken einwandfreier Qualität abgebrochen. Die Druckauflage kann durch Nacherhitzen der entwickelten Druckform auf ca. 230-240° C noch beträchtlich gesteigert werden. Eine Vorbehandlung des Trägers mit Polyvinylphosphonsäure steigert die hydrophilen Eigenschaften der Nichtbildstellen.

Ähnliche Ergebnisse werden erhalten, wenn anstelle der Verbindung Nr. 7 die gleiche Menge der Verbindung Nr. 15 verwendet wird.

*Beispiel 14*

In diesem Beispiel wird die Eignung von unterschiedlichen Orthoester/Säurespender-Kombinationen als Bestandteile positiv arbeitender Kopiermassen gezeigt:

Platten aus a) gebürstetem oder b) elektrochemisch aufgerauhtem und anodisiertem Aluminium werden mit einer Lösung aus

4,7 Gt Novolak nach Beispiel 1,
1,4 Gt polymerem Orthoester,
0,23 Gt Säurespender,
0,03 Gt Kristallviolettbase, und
93,4 Gt Methyläthylketon

schleuderbeschichtet, wobei je nach verwendetem Träger Schichtdicken von a) 1,2 µm bzw. b) 1,8 µm resultieren. Die Platten werden mit dem im Beispiel 8 genannten Gerät bildmässig belichtet und mit dem Entwickler des Beispiels 1 entwickelt. In allen Fällen wird ein positives Abbild der Vorlage erhalten. Über spezielle Bedingungen informiert Tabelle 4.

Tabelle 4

| Beispiel | Verbindung Nr. | Säurespender | Träger | Belichtungszeit (s) |
|---|---|---|---|---|
| 14 | 3 | 2,5-Diäthoxy-4-(p-tolylmercapto)benzoldiazoniumtetrafluoroborat | b | 6 |
| 15 | 9 | 2,5-Diäthoxy-4-(p-tolylmercapto)benzoldiazoniumhexafluorophosphat | a | 12 |
| 16 | 1 | 2-(Naphth-1-yl)-4,6-bistrichlormethyl-s-triazin | a | 12 |
| 17 | 2 | Säurespender aus Beispiel 1 | b | 8 |
| 18 | 6 | 1,2-Naphthochinon-2-diazid-4-sulfonsäurechlorid | b | 4 |
| 19 | 5 | 2-(4-Methoxystyryl)-4,6-bistrichlormethyl-s-triazin | b | 15 |
| 20 | 16 | 4-(2-Fur-2-ylvinyl)-6-trichlormethylpyr-2-on | a | 15 |

*Beispiel 21*

Eine Aluminiumplatte aus elektrolytisch aufgerauhtem, anodisiertem und mit Polyvinylphosphonsäure vorbehandeltem Aluminium wird mit einer 1,8 µm dicken Schicht aus

4,7 Gt Novolak nach Beispiel 1,
1,4 Gt Verbindung Nr. 3a,
0,23 Gt Säurespender nach Beispiel 7, und
0,01 Gt Kristallviolettbase

versehen. Diese Schicht wird mit einem Argon-Laser von 16-W-Lichtleistung über alle Spektrallinien bildmässig bestrahlt, wobei der Laserstrahl durch ein Objektiv auf einen Fleck mit einem Durchmesser von 20 µm focussiert wird. Durch Variation der Schreibgeschwindigkeiten wird die Empfindlichkeit der einzelnen Kombinationen ermittelt. Die belichteten Schichtteile werden innerhalb von 60 s beim Behandeln mit dem Entwickler von Beispiel 1 herausgelöst. Durch Einfärben der unbestrahlten Bereiche mit fetter Farbe lässt sich die Laserspur noch deutlicher hervorheben.

Die maximale Schreibgeschwindigkeit beträgt 100 m/s.

*Beispiel 22*

Die im Beispiel 13 beschriebene Schicht auf elektrolytisch aufgerauhtem, anodisiertem und mit Polyvinylphosphonsäure vorbehandeltem Aluminiumträger wird in 3 cm Entfernung vor dem Austrittsfenster eines Philips-Feinstruktur-Röntgengenerators angeordnet und dem Bremsstrahlungskontinuum und der Cu-Eigenstrahlung einer Cu-Kathode ausgesetzt. Bei einer Röhrenspannung von 50 kV und einer Stromstärke von 40 mA wird 25 min bestrahlt. Die bestrahlten Bereiche werden mit dem Entwickler aus Beispiel 1 ausgewaschen.

*Beispiel 23*

Zur Herstellung dicker Resistschichten wird eine Lösung hergestellt, welche enthält

35 Gew.% Äthylenglykolmonomethyläther,
20 Gew.% Methyläthylketon,
20 Gew.% Kresol-Formaldehyd-Novolak nach Beispiel 1,
7,5 Gew.% Phenol-Formaldehyd-Novolak des Schmelzbereichs 110-120° C (nach DIN 53181),
7,2 Gew.% Polyacetal aus Isobutyraldehyd und Triäthylenglykol,
2,4 Gew.% Verbindung Nr. 4,
5,0 Gew.% Polyäthylenglykol des mittleren Molgewichts 1800-2200,
0,38 Gew.% Säurespender nach Beispiel 19,
0,02 Gew.% Kristallviolettbase,
2,5 Gew.% modifiziertes Silikonglykol (handelsübliches Lackhilfsmittel).

Damit wird eine biaxial verstreckte und thermofixierte 25 µm dicke Folie aus Polyäthylenterephthalat, die mit einer Lösung von Trichloressigsäure und Polyvinylalkohol vorbehandelt ist, so beschichtet und getrocknet, dass darauf eine 20 µm dicke gleichmässige Resistschicht entsteht. Diese wird gegen Staub und Verkratzungen noch durch Aufkaschieren einer Polyolefindeckfolie von 25 µm Dicke geschützt.

Zur Herstellung von Leiterplatten wird dieser Positivtrockenresist nach Abziehen der Deckfolie in einem handelsüblichen Laminator auf einen gereinigten vorgewärmten Träger laminiert, der aus einem Isolierstoffmaterial mit 35 µm dicker Kupferauflage besteht. Nach Abkühlen, Abziehen der Trägerfolie, eventuell Nachtrocknen, 20 s Belichten unter der Vorlage eines Schaltungsplanes mit einer 5-kW-Metallhalogenidlampe im Abstand 140 cm und Sprühentwickeln der vom Licht getroffenen und veränderten Schichtpartien erhält man eine bildmässige Resistschicht.

Der Entwickler besteht aus 0,8% Na-Metasilikat $\cdot 9 H_2O$, 0,5% NaOH und 0,8% n-Butanol, gelöst in deionisiertem Wasser, und kann je nach Schichtdicke, Trocknung und gewünschter Entwicklungszeit noch mit Wasser weiter verdünnt werden.

Das vorlagengetreu erzeugte Bild ist resistent

gegen die üblichen Ätzbedingungen bei der Herstellung von Leiterplatten und ist auch galvanoresistent bei der Herstellung durchkontaktierter Schaltungen. Zur Herstellung von vergoldeten Steckerleistenkontakten können die stehengebliebenen Schichtteile nochmals belichtet, entwickelt und galvanisiert werden.

Mit dieser Schicht sind trotz ihrer Dicke, die durch zweimaliges Laminieren noch verdoppelt werden kann, relativ kurze Belichtungszeiten möglich, welche bei gleich dicken Positivschichten auf Basis von Naphthochinondiaziden nicht erreichbar sind. Nach den nötigen üblichen Verarbeitungsschritten kann der Resist bei Bedarf leicht mit Lösungsmitteln wie Aceton oder vorteilhaft mit wässrig-alkalischen Strippern, z.B. 5%ige Natronlauge, entschichtet werden.

Die gleiche Resistbeschichtungslösung kann auch zur Herstellung von Nickelrotationsgalvanozylindern für den textilen Siebdruck verwendet werden. Dazu wird ein Nickelzylinder mindestens 30 µm dick beschichtet, der wie üblich mit einer elektrisch leitenden Trennschicht versehen ist. Die Beschichtung geschieht durch Aufsprühen mittels einer mit Pressluft betriebenen Sprühpistole, wobei Konzentration der Lösung, Düsendicke und -form sowie Umdrehungs- und Vorschubgeschwindigkeit aufeinander abgestimmt werden. Es wird unter einer Strich- oder autotypischen Positivvorlage rundbelichtet und durch Übergiessen und Sprühen wie vorstehend entwickelt. Die Druckform wird nun galvanisch dadurch aufgebaut, dass beim folgenden Vernickeln sich rund um die stehengebliebenen bildmässigen Schichtreste eine immer dicker werdende Nickelhaut bildet. Wenn die günstigste Dicke erreicht ist, wird die so gebildete Rundschablone axial vom Formzylinder abgezogen und druckfertig gemacht.

## Patentansprüche

1. Strahlungsempfindliches Gemisch, das als wesentliche Bestandteile a) eine durch Einwirkung von aktinischer Strahlung eine Säure bildende Verbindung und b) eine polymere Verbindung mit wiederkehrenden durch Säure spaltbaren Orthocarbonsäureestergruppierungen in der Hauptkette enthält, wobei die Löslichkeit der Verbindung b in einem flüssigen Entwickler durch Einwirkung von Säure erhöht wird, dadurch gekennzeichnet, dass die polymere Verbindung mit wiederkehrenden Orthocarbonsäureestergruppierungen aus wiederkehrenden Einheiten der allgemeinen Formel I aufgebaut ist:

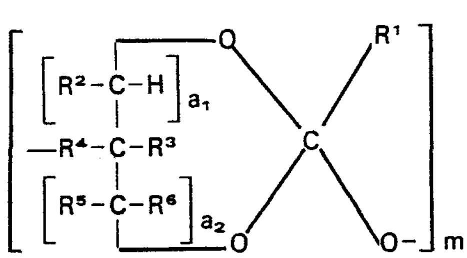

(I)

worin

$R^1$ ein Wasserstoffatom, ein Alkyl-, Cycloalkyl- oder Arylrest ist,

$R^2$, $R^3$ und $R^5$ gleich oder verschieden sind und Wasserstoffatome, Alkyl- oder Arylreste bedeuten,

$R^4$ eine Alkylengruppe oder — wenn $a_1 = a_2 = 1$ ist — auch eine Alkylenoxygruppe, wobei die Alkylengruppen durch Heteroatome oder ungesättigte oder ringförmige Gruppen unterbrochen sein können,

$R^6$ ein Wasserstoffatom oder eine Methylgruppe,

$a_1$ und $a_2$ jeweils 0, 1 oder 2

$a_1 + a_2$ 1 oder 2, und

m eine Zahl von 3 bis 200

bedeuten.

2. Strahlungsempfindliches Gemisch nach Anspruch 1, dadurch gekennzeichnet, dass es eine Verbindung gemäss Formel I enthält, worin

$R^3$ ein Wasserstoffatom oder einen Alkylrest mit 1 bis 6 C-Atomen,

$R^4$ eine Alkylenoxymethylgruppe mit 3 bis 13 C-Atomen, in der die Alkylengruppe durch Sauerstoffatome oder Cycloalkylgruppen unterbrochen sein kann,

$R^2$, $R^5$ und $R^6$ Wasserstoffatome bedeuten, und

$a_1 = a_2 = 1$ ist.

3. Strahlungsempfindliches Gemisch nach Anspruch 1, dadurch gekennzeichnet, dass es eine Verbindung gemäss Formel I enthält, worin $R^1$ ein Wasserstoffatom ist.

4. Strahlungsempfindliches Gemisch nach Anspruch 1, dadurch gekennzeichnet, dass es eine Verbindung gemäss Formel I enthält, worin m eine Zahl von 5 bis 150 bedeutet.

5. Strahlungsempfindliches Gemisch nach Anspruch 1, dadurch gekennzeichnet, dass es zusätzlich ein wasserunlösliches, in wässrig-alkalischen Lösungen lösliches polymeres Bindemittel enthält.

6. Strahlungsempfindliches Gemisch nach Anspruch 5, dadurch gekennzeichnet, dass es

30 bis 90 Gew.% polymeres Bindemittel,
8 bis 69,9 Gew.% durch Säure spaltbare Verbindung b, und
0,1 bis 10 Gew.% Säure bildende Verbindung a

enthält.

7. Verfahren zur Herstellung von Reliefbildern, bei dem man ein strahlungsempfindliches Aufzeichnungsmaterial aus einem Schichtträger und einer Aufzeichnungsschicht, die a) eine durch Einwirkung von aktinischer Strahlung eine Säure bildende Verbindung, und b) eine polymere Verbindung mit wiederkehrenden durch Säure spaltbaren Orthocarbonsäureestergruppierungen in der Hauptkette enthält, wobei die Löslichkeit der Verbindung b in einem flüssigen Entwickler durch Einwirkung von Säure erhöht wird, bildmässig mit aktinischer Strahlung in solcher Dosis bestrahlt, dass die Löslichkeit der Aufzeichnungsschicht in einem flüssigen Entwickler zunimmt, und danach die bestrahlten Schichtteile mittels eines flüssigen

Entwicklers auswäscht, dadurch gekennzeichnet, dass man eine polymere Verbindung b der allgemeinen Formel I verwendet,

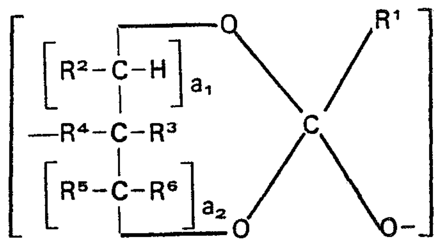

(I)

worin

$R^1$ ein Wasserstoffatom, ein Alkyl-, Cycloalkyl- oder Arylrest ist,

$R^2$, $R^3$ und $R^5$ gleich oder verschieden sind und Wasserstoffatome, Alkyl- oder Arylreste bedeuten, eine Alkylengruppe oder — wenn $a_1 = a_2 = 1$ ist — auch eine Alkylenoxygruppe, wobei die Alkylengruppen durch Heteroatome oder ungesättigte oder ringförmige Gruppen unterbrochen sein können,

$R^6$ ein Wasserstoffatom oder eine Methylgruppe,

$a_1$ und $a_2$ jeweils 0, 1 oder 2,

$a_1 + a_2$ 1 oder 2, und

m eine Zahl von 3 bis 200

bedeuten.

## Claims

1. A radiation-sensitive mixture which contains, as the essential constituents, a) a compound which forms an acid under the action of actinic radiation, and b) a polymeric compound having recurrent ortho-carboxylic acid ester groupings, which can be split by acid, in the main chain, the solubility of the compound b in a liquid developer being increased by the action of acid, characterized in that the polymeric compound has recurrent ortho-carboxylic acid ester groupings and is built up from recurrent units of the general formula (I):

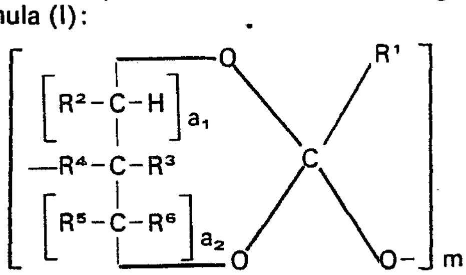

(I)

wherein $R^1$ is a hydrogen atom or an alkyl, cycloalkyl or aryl radical, $R^2$, $R^3$ and $R^5$ are identical or different and denote hydrogen atoms or alkyl or aryl radicals, $R^4$ denotes an alkylene group or −if $a_1 = a_2 = 1$− also an alkyleneoxy group, it being possible for the alkylene groups to be interrupted by heteroatoms or by unsaturated or cyclic groups, $R^6$ denotes a hydrogen atom or a methyl group, $a_1$ and $a_2$ each denote 0, 1 or 2, $a_1 + a_2$ denotes 1 or 2 and m denotes a number from 3 to 200.

2. A radiation-sensitive mixture as claimed in claim 1, which contains a compound according to formula (I), wherein $R^3$ denotes a hydrogen atom or an alkyl radical having 1-6 C atoms, $R^4$ denotes an alkyleneoxymethyl group having 3-13 C atoms, wherein the alkylene group can be interrupted by oxygen atoms or cycloalkyl groups, and $R^2$, $R^5$ and $R^6$ denote hydrogen atoms, with $a_1 = a_2 = 1$.

3. A radiation-sensitive mixture as claimed in claim 1, which contains a compound according to formula (I), wherein $R^1$ is a hydrogen atom.

4. A radiation-sensitive mixture as claimed in claim 1, which contains a compound according to formula (I), wherein m denotes a number from 5 to 150.

5. A radiation-sensitive mixture as claimed in claim 1, which additionally contains a polymeric binder which is insoluble in water and soluble in aqueous-alkaline solutions.

6. A radiation-sensitive mixture as claimed in claim 5, which contains 30 to 90% by weight of a polymeric binder, 8 to 69.9% by weight of a compound b which can be split by acid, and 0.1 to 10% by weight of an acid-forming compound a.

7. A process for the production of relief images, in which a radiation-sensitive recording material which consists of a layer support and a recording layer which contains a) a compound which forms an acid under the action of actinic radiation, and b) a polymeric compound having recurrent ortho-carboxylic acid ester groupings, which can be split by acid, in the main chain, the solubility of the compound b in a liquid developer being increased by the action of acid, is irradiated imagewise with actinic radiation at such a dose that the solubility of the recording layer in a liquid developer increases, and the irradiated parts of the layer are then washed out by means of a liquid developer, which comprises using a polymeric compound b of the general formula (I):

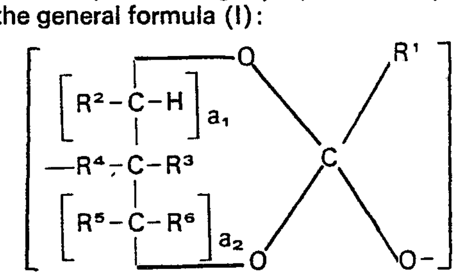

(I)

wherein $R^1$ is a hydrogen atom or an alkyl, cycloalkyl or aryl radical, $R^2$, $R^3$ and $R^5$ are identical or different and denote hydrogen atoms or alkyl or aryl radicals, $R^4$ denotes an alkylene group or −if $a_1 = a_2 = 1$− also an alkyleneoxy group, it being possible for the alkylene groups to be interrupted by heteroatoms or by unsaturated or cyclic groups, $R^6$ denotes a hydrogen atom or a methyl group, $a_1$ and $a_2$ each denote 0, 1 or 2, $a_1 + a_2$ denotes 1 or 2 and m denotes a number from 3 to 200.

## Revendications

1. Mélange sensible aux rayonnements dont les constituants principaux sont:

a) un composé qui, sous l'effet d'un rayonnement actinique, donne naissance à un acide, et

b) un composé polymère renfermant, dans sa chaîne principale, des groupes esters d'orthoacides carboxyliques récurrents, décomposables par l'acide, la solubilité du composé b dans un révélateur liquide se trouvant augmentée sous l'action de l'acide, caractérisé en ce que la structure du composé polymère, renfermant des groupes esters d'orthoacides carboxyliques récurrents, se présente sous la forme d'une succession d'unités, répondant à la formule générale (I):

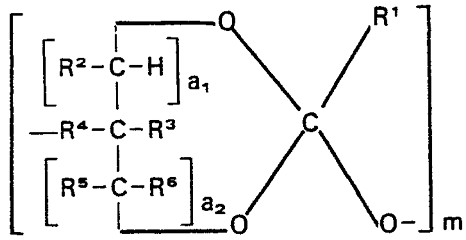
(I)

dans laquelle:

$R^1$ est un atome d'hydrogène, un reste alkyle, cycloalkyle ou aryle;

$R^2$, $R^3$ et $R^5$ sont identiques ou différents et représentent des atomes d'hydrogènes, des restes alkyle ou aryle;

$R^4$ représente un groupe alkylène ou encore, lorsque $a_1 = a_2 = 1$, un groupe alkylène-oxy, les groupes alkylène pouvant être interrompus par des hétéroatomes ou par des groupements insaturés ou cycliques;

$R^6$ est un atome d'hydrogène ou un groupe méthyle;

$a_1$ et $a_2$ valent, selon le cas, 0, 1 ou 2;

$a_1 + a_2$ est égal à 1 ou 2, et

m est un nombre compris entre 3 et 200.

2. Mélange sensible aux rayonnements selon la revendication 1, caractérisé en ce qu'il renferme un composé de formule (I), dans laquelle:

$R^3$ représente un atome d'hydrogène ou un reste alkyle comptant 1 à 6 atomes de C;

$R^4$ représente un groupe alkylène-oxyméthyle comptant 3 à 13 atomes de C, dans lequel les groupes alkylène peuvent être interrompus par des atomes d'oxygène ou des groupes cycloalkyle;

$R^2$, $R^5$ et $R^6$ sont des atomes d'hydrogène, et $a_1 = a_2 = 1$.

3. Mélange sensible aux rayonnements selon la revendication 1, caractérisé en ce qu'il renferme un composé de formule (I), dans laquelle $R^1$ est un atome d'hydrogène.

4. Mélange sensible aux rayonnements selon la revendication 1, caractérisé en ce qu'il renferme un composé répondant à la formule (I), dans laquelle m est un nombre compris entre 5 et 150.

5. Mélange sensible aux rayonnements selon la revendication 1, caractérisé en ce qu'il renferme, en outre, un liant polymère insoluble dans l'eau, mais soluble dans les solutions alcalines aqueuses.

6. Mélange sensible aux rayonnements selon la revendication 5, caractérisé en ce qu'il renferme:

| | |
|---|---|
| de 30 à 90% | en poids d'un liant polymère; |
| de 8 à 69,9% | en poids d'un composé b décomposable par l'acide, et |
| de 0,1 à 10% | en poids d'un composé a donnant naissance à un acide. |

7. Procédé pour la réalisation d'images en relief, selon lequel on irradie un matériel d'enregistrement sensible aux rayonnements composé d'un support et d'une couche d'enregistrement, laquelle est constituée

a) d'un composé qui, sous l'effet d'un rayonnement actinique, donne naissance à un acide, et

b) d'un composé polymère renfermant, dans sa chaîne principale, des groupes esters d'orthoacides carboxyliques récurrents, décomposables par l'acide, la solubilité du composé b dans un révélateur liquide se trouvant augmentée sous l'action de l'acide et l'irradiation se faisant par un rayonnement actinique à dose telle que la solubilité de la couche d'enregistrement dans un révélateur liquide s'accroît et que les parties exposées sont isolées au moyen d'un révélateur liquide, caractérisé en ce que l'on utilise un composé polymère b de formule générale (I):

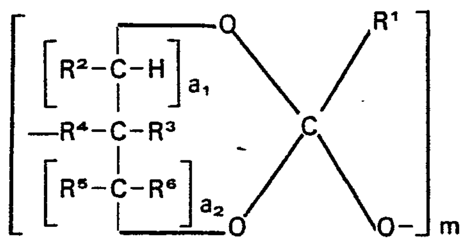
(I)

dans laquelle:

$R^1$ est un atome d'hydrogène, un reste alkyle, cycloalkyle ou aryle;

$R^2$, $R^3$ et $R^5$ sont identiques ou différents et représentent des atomes d'hydrogène, des restes alkyle ou aryle;

$R^4$ représente un groupe alkylène ou encore, lorsque $a_1 = a_2 = 1$, un groupe alkylène-oxy, les groupes alkylène pouvant être interrompus par des hétéroatomes, ou par des groupes insaturés ou cycliques;

$R^6$ est un atome d'hydrogène ou un groupe méthyle;

$a_1$ et $a_2$ valent, selon le cas, 0, 1 ou 2;

$a_1 + a_2$ est égal à 1 ou 2, et

m est un nombre compris entre 3 et 200.